# EUROPÄISCHE PATENTSCHRIFT

(11) **EP 0 795 050 B1**
(45) Veröffentlichungstag und Bekanntmachung des Hinweises auf die Patenterteilung: **28.07.1999**
(21) Anmeldenummer: 95936440.7
(22) Anmeldetag: 14.11.1995
(51) Int. Cl.: C30B 23/00

(54) **VERFAHREN UND VORRICHTUNG ZUM HERSTELLEN VON SILICIUMCARBID-EINKRISTALLEN DURCH SUBLIMATIONSZÜCHTUNG**
PROCESS AND DEVICE FOR SUBLIMATION GROWING SILICON CARBIDE MONOCRYSTALS
PROCEDE ET DISPOSITIF DE PRODUCTION DE MONOCRISTAUX EN CARBURE DE SILICIUM PAR FORMATION DE CRISTAUX PAR SUBLIMATION

(30) Priorität: 01.12.1994 DE 4442819
(43) Veröffentlichungstag der Anmeldung: 17.09.1997
(73) Patentinhaber: SIEMENS AKTIENGESELLSCHAFT, 80333 München (DE)
(72) Erfinder: STEPHANI, Dietrich, D-91088 Bubenreuth (DE); VÖLKL, Johannes, D-91056 Erlangen (DE)
(86) Internationale Anmeldenummer: DE9501576
(87) Internationale Veröffentlichungsnummer: WO9617113

(56) Entgegenhaltungen:
- EP-A- 0 554 047
- US-A- 4 147 572
- KRISTALL UND TECHNIK, Bd. 14, Nr. 6, 1979 BERLIN, DE, Seiten 729-740, VODAKOV 'Epitaxial growth of silicon carbide layers...'
- PATENT ABSTRACTS OF JAPAN vol. 17 no. 55 (C-1023) ,3.Februar 1993 & JP,A,04 265294 (TOSHIBA) 21.September 1992,
- SEMICONDUCTOR SCIENCE AND TECHNOLOGY, Bd. 7, Nr. 7, Juli 1992 LONDON GB, Seiten 863-880, IVANOV ET AL 'recent developments in SiC ..'

## Beschreibung

Die Erfindung betrifft ein Verfahren und eine Vorrichtung zum Herstellen von Siliciumcarbid-Einkristallen.

Bei der Sublimationszüchtung von Einkristallen aus Siliciumcarbid (SiC) wird in einem Vorratsraum ein Vorrat von festem Siliciumcarbid, im allgemeinen in Pulverform oder in Form eines vorgefertigten massiven SiC-Kristalls, erhitzt und wenigstens teilweise sublimiert. Das sublimierte SiC wird auf einen in einer Reaktionskammer angeordneten SiC-Keimkristall aufgewachsen. Wegen den zur Sublimationszüchtung erforderlichen hohen Temperaturen von im allgemeinen über 2000°C bestehen die den Vorratsraum und den Reaktionsraum umschließenden Gefäßwände aus den temperaturfesten Materialien Graphit oder Metallcarbiden. Auf dem Weg zwischen dem Vorratsraum und dem Keimkristall kommt es nun jedoch zu einem unvermeidlichen Kontakt des sublimierten SiC in der Gasphase mit den Gefäßwänden. Dadurch können in den Materialien der Gefäßwände enthaltene Verunreinigungen von der siliciumreichen Gasphase des SiC herausgelöst und anschließend in den aufwachsenden SiC-Einkristall gelangen. Ferner kann sich auch die stöchiometrische Zusammensetzung des SiC in der Gasphase durch chemische Reaktionen des Siliciums in der SiC-Gasphase mit den Graphit- oder Metallcarbidwänden verändern. Dies kann zu kohlenstoffreichen Ausscheidungen im aufwachsenden SiC-Einkristall führen.

Bei den aus *US-A-2,854,364* und *AT-PS-243* 858 bekannten Lely-Sublimationsprozessen zum Züchten von SiC-Einkristallen werden in einem Graphitgefäß Bruchstücke aus SiC so aufgeschichtet, daß sie einen Hohlraum (Sublimationsraum) einschließen. Bei einer Temperatur von etwa 2500°C backen die SiC-Bruchstücke zusammen und an den zusammengebackenen Bruchstücken bilden sich kleine SiC-Kristalle. Der Sublimationsraum ist bei diesem bekannten Verfahren nicht gasdicht abgeschlossen. Durch Zwischenräume zwischen den SiC-Bruchstücken werden insbesondere auch Dotiergase geführt zum Dotieren der wachsenden SiC-Kristalle.

Aus der *DE-OS* 24 *09* 005 und der korrespondierenden *US-A-4,147,572* sind ein Verfahren und eine Vorrichtung zur epitaktischen Herstellung von einkristallinen SiC-Schichten auf SiC-Keimkristallen bekannt, bei denen eine polykristalline SiC-Platte als SiC-Dampfquelle in einem Abstand von nicht mehr als dem 0,2fachen der linearen Abmessung der SiC-Platte von mehreren SiC-Keimkristallen angeordnet ist. Als Abstandhalter dient ein Graphitanschlagring, der auf einen Graphithalter für die Keimkristalle aufgesetzt ist und auf dem auf der gegenüberliegenden Seite die SiC-Platte angeordnet ist. Ein oder mehrere solcher Wachstumszellen aus Graphithalter, Keimkristallen, Graphitanschlagring und SiC-Platte werden in einen Graphittiegel eingebracht, der in einen Ofen eingesetzt wird. Der Sublimationsprozeß wird im Ofen bei einem Druck von etwa 1 bar bis 10⁻⁵ Torr und bei Temperaturen zwischen 1600°C und 2400°C durchgeführt. Zum Dotieren der SiC-Epitaxieschichten werden durch eine Öffnung Dotiergase in den Graphittiegel eingeleitet.

Aus *JP-A-04-055397* ist bekannt, als Substrat für eine Sublimationszüchtung von SiC-Einkristallen durch chemische Dampfphasenabscheidung (CVD) hergestelltes polykristallines β-Sic zu verwenden.

Bei einer weiteren, aus *US-A-5,288,326* bekannten Vorrichtung zum Herstellen von SiC-Einkristallen werden in einer Reaktionskammer aus einem Arbeitsgasgemisch mit den Hauptkomponenten Silan, Propan und Wasserstoff feste SiC-Partikel erzeugt, die in eine Sublimationskammer fallen und dort bei Temperaturen zwischen 2000°C und 2400°C sublimiert werden. Das sublimierte SiC wird auf einen Keimkristall aufgewachsen.

Der Erfindung liegt nun die Aufgabe zugrunde, ein Verfahren und eine Vorrichtung zur Sublimationszüchtung von SiC-Einkristallen mit einer gegenüber dem Stand der Technik verbesserten Kristallqualität anzugeben.

Diese Aufgabe wird gemäß der Erfindung gelöst mit einem Verfahren mit den Merkmalen des Anspruchs 1 und einer Vorrichtung mit den Merkmalen des Anspruchs 3. Es wird wenigstens eine von einer gasdichten Wandung umgebene Reaktionskammer vorgesehen. Die Wandung der wenigstens einen Reaktionskammer besteht wenigstens auf ihrer der Reaktionskammer zugewandten Innenseite aus durch chemische Dampfphasenabscheidung (Chemical Vapour Depositition = CVD) hergestelltem Siliciumcarbid (SiC). Dieses wenigstens die Innenseite der Wandung der Reaktionskammer bildende Siliciumcarbid ist nun wenigstens in einem Sublimationsbereich der Wandung als Vorrat (Dampfquelle) für den Sublimationsprozeß vorgesehen. Durch Erhitzen wird der als Vorrat bestimmte Teil des Siliciumcarbids wenigstens teilweise sublimiert. Das sublimierte Siliciumcarbid wird als Siliciumcarbid-Einkristall auf wenigstens einem Keimkristall aufgewachsen. Da die Innenseite der Wandung des Reaktionsraumes aus Siliciumcarbid besteht, wird das stöchiometrische Verhältnis von Silicium (Si) zu Kohlenstoff (C) im aufwachsenden SiC-Einkristall von der Wandung praktisch nicht mehr beeinflußt. Mit einem CVD-Prozeß kann SiC hoher Reinheit hergestellt werden. Deshalb können bei Verwendung von mit einem CVD-Prozeß hergestelltem SiC wenigstens für die Innenseite der Wandung auch Verunreinigungen des SiC-Einkristalls bei der Sublimationszüchtung verringert werden.

Vorteilhafte Weiterbildungen und Ausgestaltungen des Verfahrens und der Vorrichtung ergeben sich aus den jeweils abhängigen Ansprüchen.

Das stöchiometrische Verhältnis von Silicium (Si) zu Kohlenstoff (C) im Siliciumcarbid wenigstens des Sublimationsbereichs der Wandung weicht vorzugsweise um nicht mehr als etwa 5 % von 1 ab. Der Anteil an unbeabsichtigen Verunreinigungen im Siliciumcarbid der Wandung liegt vorzugsweise nicht wesentlich höher als 10¹⁵cm⁻³.

Das Siliciumcarbid der Wandung der Reaktionskammer, insbesondere im Sublimationsbereich, ist vorzugsweise zumindest weitgehend polykristallin oder auch zumindest weitgehend amorph. Dadurch können beim CVD-Prozeß höhere Wachstumsraten eingestellt werden.

Die Wandung wird in einer vorteilhaften Ausführungsform aus vorab gefertigten Formkörpern gebildet. Vorzugsweise werden die Formkörper durch Verwendung von elementarem Silicium gasdicht aneinandergefügt.

Der wenigstens eine Keimkristall kann in der wenigstens einen Reaktionskammer angeordnet sein oder auch einen Teil der Wandung der Reaktionskammer bilden.

In einer weiteren Ausführungsform der Vorrichtung sind der wenigstens einen Reaktionskammer Mittel zugeordnet zum Einstellen einer zur Sublimation des SiC ausreichenden Temperatur im Sublimationsbereich als auch einer bestimmten Temperaturverteilung zwischen Sublimationsbereich und Keimkristall.

Zur weiteren Erläuterung der Erfindung wird auf die Zeichnung Bezug genommen, in deren
- FIG 1: eine Ausführungsform der Vorrichtung zum Herstellen von SiC-Einkristallen in einem Querschnitt,
- FIG 2 und 3: Ausführungsformen einer Vorrichtung zum Herstellen von Formkörpern für eine Reaktionskammer,
- FIG 4 und 5: Ausführungsbeispiele zum Herstellen von Formkörpern für eine Reaktionskammer und
- FIG 6 bis 10: Ausführungsbeispiele zum Herstellen der Wandung der Reaktionskammer
schematisch dargestellt sind. Einander entsprechende Teile sind mit denselben Bezugszeichen versehen.

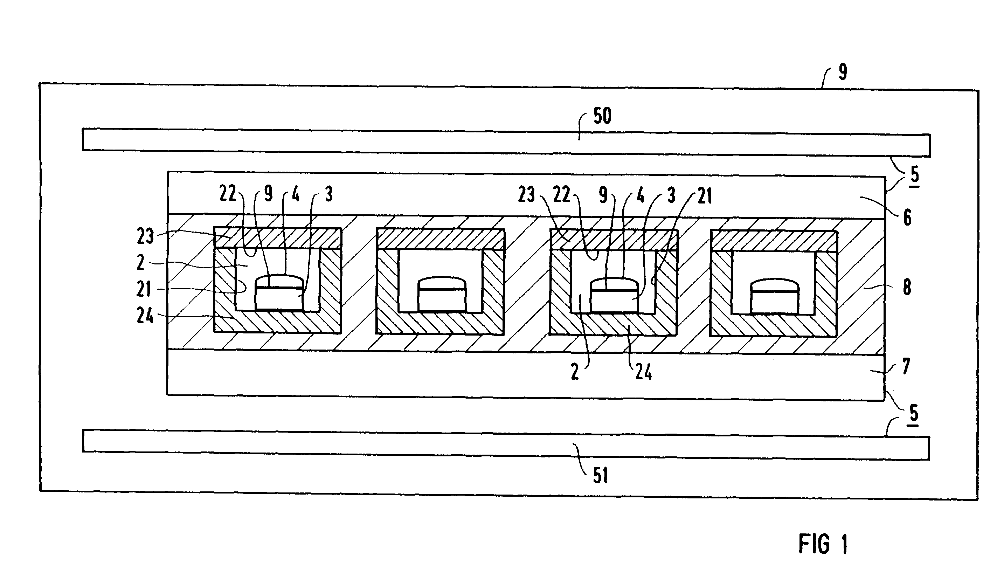

In FIG 1 sind mehrere Reaktionskammern jeweils mit 2, in den Reaktionskammern 2 angeordnete Keimkristalle mit 3, auf Kristallisationsflächen 9 der Keimkristalle 3 aufwachsende SiC-Einkristalle mit 4, thermische Mittel mit 5, zwei einzelne Heizeinrichtungen mit 50 und 51, zwei Suszeptoren mit 6 und 7, eine Wärmeisolierung mit 8, ein Rezipient mit 9, die Reaktionskammern 2 jeweils umgebende Wandungen mit 20, die der jeweiligen Reaktionskammer 2 zugewandte Innenseite jeder Wandung mit 21, ein dem Keimkristall 3 gegenüberliegender Sublimationsbereich dieser Innenseiten 21 mit 22 und jeweils zwei eine Wandung 20 bildende Formkörper mit 23 und 24 bezeichnet.

Jede Reaktionskammer 2 ist von der zugehörigen Wandung 20 vollständig gasdicht umschlossen. Es ist also praktisch kein Gastransport durch die Wandung 20 möglich. Die Wandung 20 jeder Reaktionskammer 2 besteht ferner wenigstens auf ihrer Innenseite 21 aus Siliciumcarbid.

In der dargestellten Ausführungsform ist die Wandung 20 aus den zwei Formkörpern 23 und 24 zusammengesetzt. Der Formkörper 24 hat beispielsweise die Form eines zylindrischen oder quaderförmigen Topfes und kann auch selbst aus mehreren einzelnen Formkörpern zusammengesetzt sein. Der Formkörper 23 ist vorzugsweise plattenförmig ausgebildet und kann wie ein Deckel auf den topfartigen Formkörper 24 aufgesetzt werden, so daß ein abgeschlossener Hohlraum zwischen den beiden Formkörpern 23 und 24 als Reaktionskammer 2 entsteht. Die Formkörper 23 und 24 sind selbst gasundurchlässig, also insbesondere nicht porös, und miteinander gasdicht verbunden. Beispielsweise können die Formkörper 23 und 24 durch Vorsintern vorzugsweise im Vakuum bei Temperaturen von typischerweise zwischen 1500°C und 2200°C miteinander verbunden werden. Die Formkörper 23 und 24 können massive Körper aus SiC sein oder auch Verbundkörper aus SiC und einem anderen temperaturfesten Material wie Graphit. Das SiC der Formkörper 23 und 24 wird durch chemisches Abscheiden aus der Gasphase (CVD) hergestellt. Durch CVD kann SiC mit vergleichsweise geringen Verunreinigungen hergestellt werden. Der Anteil von unerwünschten Fremdatomen (Verunreinigungen) in den Formkörpern 23 und 24 liegt im allgemeinen unter 10¹⁵ cm⁻³ und kann sogar bis unter etwa 10¹³ cm⁻³ eingestellt werden. Auch der aufwachsende SiC-Einkristall 4 weist somit eine entsprechend hohe Reinheit auf.

In jeder Reaktionskammer 2 ist nun wenigstens ein Keimkristall 3 angeordnet, beispielsweise wie dargestellt auf dem Boden des topfartigen Formkörpers 24. Der wenigstens eine Keimkristall 3 kann aber auch einen Teil der Wandung 20 bilden. Beispielsweise kann der Boden des Formkörpers 24 teilweise mit dem wenigstens einen Keimkristall 3 gebildet sein. Eine der Reaktionskammer 2 zugewandte Oberfläche des Keimkristalls 3 bildet die Kristallisationsfläche 9 für den SiC-Einkristall 4.

Mit Hilfe der thermischen Mittel 5 werden nun einerseits die Wandung 20 wenigstens in ihrem Sublimationsbereich 22 auf eine für eine gewünschte Sublimationsrate ausreichende Temperatur gebracht und andererseits eine gewünschte Temperaturverteilung zwischen Sublimationsbereich 22 und Keimkristall 3 eingestellt. Das feste SiC des Sublimationsbereiches 22 wird dadurch wenigstens teilweise sublimiert, und das sublimierte SiC in der Gasphase wird vom Sublimationsbereich 22 zum Keimkristall 3 transportiert und kristallisiert dort als SiC-Einkristall 4 aus. Das SiC des Sublimationsbereiches 22 der Wandung 20 hat somit neben seiner Funktion als Bestandteil der Wandung 20 auch die Funktion als Vorrat (Quelle) für den Sublimationsprozeß. Die Prozeßtemperaturen werden vorzugsweise zwischen 1600°C und 2400°C eingestellt. Der Temperaturgradient zwischen Sublimationsbereich 22 und Keimkristall 3 wird vorzugsweise zwischen etwa 1°C/cm und etwa 25°C/cm eingestellt.

Als Keimkristall 3 wird vorzugsweise ein SiC-Einkristall verwendet, insbesondere des 4H-, 6H- oder 3C-Polytyps. Verwendet man als Kristallisationsfläche 9 die Kohlenstoffseite des SiC-Keimkristalls 3, so wächst ein SiC-Einkristall 4 des 4H-Polytyps auf. Erfolgt das Kristallwachstum dagegen auf der Siliciumseite des Keimkristalls 3, so ist der aufwachsende SiC-Einkristall 4 vom 6H-Polytyp. Der Druck in der Reaktionskammer 2 kann zwischen nahezu Vakuumdruck bis über Atmosphärendruck eingestellt werden und wird im allgemeinen 2 bar nicht wesentlich überschreiten. Zum Einstellen des Drucks wird vorzugsweise Wasserstoffgas oder ein Edelgas oder ein Gemisch aus wenigstens zwei dieser Gase verwendet, mit dem die Reaktionskammer 2 nach vorherigem Evakuieren gefüllt wird.

Obwohl in FIG 1 mehrere Reaktionskammern 2 dargestellt sind, kann die Vorrichtung natürlich auch nur eine Reaktionskammer 2 umfassen. Ferner können in jeder Reaktionskammer 2 auch mehrere Keimkristalle 3 vorgesehen sein.

Die thermischen Mittel 5 können auf vielfältige Art und Weise ausgebildet sein und eine oder mehrere Induktions- oder Widerstandsheizungen und wärmeisolierende Materialien zum Einstellen einer Temperaturverteilung in der Wandung 20, in der Reaktionskammer 2 und am Keimkristall 3 umfassen. In der in FIG 1 dargestellten Ausführungsform enthalten die thermischen Mittel 5 die erste Heizeinrichtung 50, die zweite Heizeinrichtung 51, die beiden Suszeptoren 6 und 7 und die Wärmeisolierung 8. Die wenigstens eine Reaktionskammer 2 ist in der Wärmeisolierung 8 angeordnet. In der dargestellten Ausführungsform sind die Reaktionskammern 2 nebeneinander in einer gemeinsamen Wärmeisolierung 8 angeordnet. Die Wärmeisolierung 8 besteht aus einem wärmeisolierenden Material mit vorbestimmter thermischer Leitfähigkeit, das vorzugsweise mit der Wandung 20 der Reaktionskammer 2 nur unwesentlich chemisch reagiert, beispielsweise SiC- oder Graphit-Pulver oder einem Graphit-Schaum. Den Sublimationsbereichen 22 der Wandungen 20 der Reaktionskammern 2 sind die erste Heizeinrichtung 50 und der erste Suszeptor 6 zum Aufnehmen der Energie und Weitergeben an die Sublimationsbereiche 22 gemeinsam zugeordnet. Den von den Sublimationsbereichen 22 abgewandten Seiten der Wandungen 20 der Reaktionskammern 2 sind die zweite Heizeinrichtung 51 sowie der zweite Suszeptor 7 gemeinsam zugeordnet. Die Suszeptoren 6 und 7 können auch entfallen, insbesondere, wenn die Heizeinrichtungen 50 und 51 Widerstandsheizungen sind. Die beiden Heizeinrichtungen 50 und 51 sind in ihren Heizleistungen vorzugsweise unabhängig voneinander steuerbar. Damit kann kontrolliert eine gewünschte Temperaturverteilung für den Sublimationsprozeß eingestellt werden.

Die thermischen Mittel 5 können aber auch aus nur einer Heizung bestehen, die beispielsweise hohlzylindrisch ausgebildet sein kann und alle Reaktionskammern 2 umgibt. Insbesondere in dieser Ausführungsform kann die Temperaturverteilung auch durch entsprechend erzeugte Inhomogenitäten in der Wärmeisolierung 8 oder einer zusätzlichen Wärmeisolierung an der von den Reaktionskammern 2 abgewandten Außenseite der Suszeptoren 6 und 7 eingestellt werden.

Alle bisher beschriebenen Komponenten der Vorrichtung sind vorzugsweise in dem Rezipienten 9 angeordnet.

Die Gestalt der Reaktionskammer 2 und ihrer Wandung 20 ist nicht auf die dargestellte Ausführungsform beschränkt. Die Wandung 20 kann prinzipiell aus beliebigen, in ihrer Gestalt aneinander angepaßten Formkörpern zusammengesetzt werden. Die Gestalt der Formkörper kann insbesondere durch Sägen oder auch Ätzen bestimmt werden.

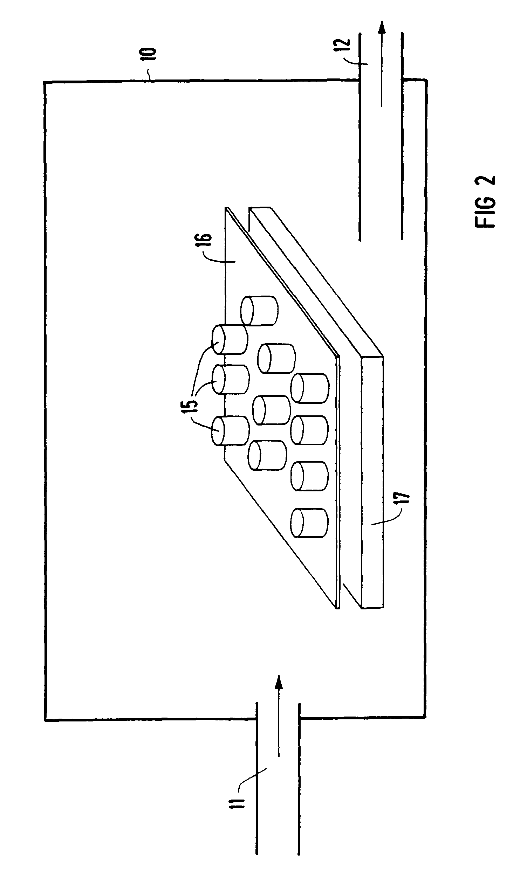

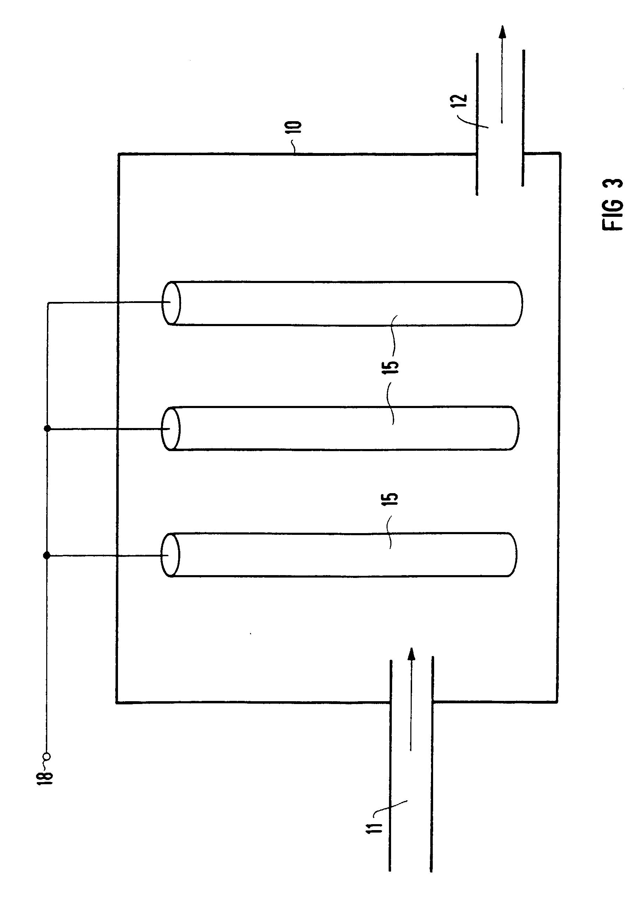

Die FIG 2 und 3 zeigen zwei Möglichkeiten zur Herstellung der Formkörper. Gemäß FIG 2 werden zunächst in einem CVD-Reaktor 10 Formsubstrate 15 auf einem Träger 16 angeordnet. Diese Formsubstrate 15 können beispielsweise wie dargestellt eine zylindrische Form oder auch die Gestalt einer Platte aufweisen. Es können insbesondere Formsubstrate 15 aus SiC, aus Graphit oder auch aus Si verwendet werden. Unter dem Träger 16 ist eine Heizplatte 17 angeordnet zum Heizen der Formsubstrate 15 auf eine für den CVD-Prozeß gewünschte Temperatur. Gemäß FIG 3 werden vorzugsweise mehrere Formsubstrate 15' in einem CVD-Reaktor 10 angeordnet. Die Formsubstrate 15' sind vorgefertigt und können beispielsweise runde oder rechteckige Stäbe oder Platten oder auch Hohlkörper sein, vorzugsweise aus hochreinem, vorzugsweise poliertem Silicium, aus Siliciumcarbid oder auch aus Graphit. Diese Formsubstrate 15' werden vorzugsweise elektrisch beheizt mit Hilfe eines elektrischen Anschlusses 18. Über eine Gaszuleitung 11 werden in beiden Ausführungsformen gemäß FIG 2 und 3 Prozeßgase in den CVD-Reaktor 10 eingebracht. Aus den Prozeßgasen scheidet sich Siliciumcarbid an den Formsubstraten 15 bzw. 15' ab. Nach dem Abscheiden des Siliciumcarbids können die Formsubstrate 15 bzw. 15' von dem abgeschiedenen Siliciumcarbid durch Abschmelzen (im Falle von Silicium als Substratmaterial) oder Ätzen (im Falle von Silicium oder Graphit als Substratmaterial) entfernt werden und der erhaltene Siliciumcarbidkörper als Formkörper für die Wandung 20 der Reaktionskammer 2 verwendet werden. Alternativ können auch das Formsubstrat 15 bzw. 15' zusammen mit dem zusätzlich abgeschiedenen SiC als Verbundformkörper für die Wandung 20 verwendet werden.

Wenn für die Formkörper für die Wandung 20 polykristallines oder amorphes SiC vorgesehen wird, kann mit einem CVD-Prozeß auch eine hohe Wachstumsrate für das auf dem Formsubstrat 15 aufwachsende SiC verglichen mit dem Aufwachsen von einkristallinem SiC erreicht werden. Die Dicke der auf dem Formsubstrat 15 aufgewachsenen SiC-Formkörper beträgt im allgemeinen zwischen etwa 1 mm und 10 cm, wenn die Wandung 20 der Reaktionskammer 2 massiv aus SiC bestehen soll. Wenn die Wandung 20 der Reaktionskammer 2 nur auf ihrer Innenseite 21, zumindest außerhalb des Sublimationsbereichs 22 mit SiC beschichtet werden soll, genügen auch schon geringe Dicken des auf dem Formsubstrat 15 aufwachsenden SiC.

zum Abscheiden der SiC-Formkörper für die Wandung 20 der Reaktionskammer 2 auf den Formsubstraten 15 können an sich bekannte CVD-Prozesse mit Prozeßgasen wie Alkanen (z.B. Methan, Propan, Butan) und Siliciumhalogenwasserstoffen (z.B. SiH₄, SiHCl₃ oder SiH₂Cl₂) oder auch Methyltrichlorsilan, wobei die Atomanteile von Silicium (Si) und Kohlenstoff (C) wenigstens annähernd gleich angestellt werden bzw. sind, und Trägergase wie Wasserstoff oder einem Edelgas verwendet werden. Vorzugsweise wird die Zusammensetzung der Prozeßgase in Abhängigkeit von der Prozeßtemperatur am Formsubstrat, die im allgemeinen zwischen 150°C und 1600°C, vorzugsweise zwischen 300°C und 1400°C, liegen kann, und von der gewünschten Wachstumsrate so eingestellt, daß sich die chemische Zusammensetzung des auf dem Formsubstrat 15 aufwachsenden SiC von der exakten stöchiometrischen Zusammensetzung von SiC um nicht mehr als 5 % unterscheidet, die Abweichung des Verhältnisses von Si zu C von 1 also nicht mehr als 5 % beträgt, d.h. 0,95 ≤ Si/C ≤ 1,05. Im wesentlichen amorphes SiC wird im allgemeinen bei Substrattemperaturen von typischerweise zwischen 150°C und 300°C hergestellt, während im wesentlichen polykristallines SiC bei höheren Substrattemperaturen von typischerweise zwischen etwa 500°C und etwa 950°C erzeugt wird. Um eine höhere Wachstumsrate zu erreichen, kann der CVD-Prozeß auch plasmaunterstützt oder photostimuliert sein.

Das Siliciumcarbid wenigstens im Sublimationsbereich 22 der Wandung 20 kann in einer besonderen Ausführungsform auch mit Dotierstoffen (beabsichtigte Fremdatome) versehen sein, um den aufwachsenden SiC-Einkristall 4 zu dotieren. Als Dotierstoffe können Akzeptoren wie beispielsweise Aluminium oder Bor, Donatoren wie beispielsweise Stickstoff oder Phosphor oder auch kompensierende tiefe Störstellendotanten wie Vanadium verwendet werden. Beim CVD-Prozeß zum Herstellen der SiC-Formkörper können solche Dotierstoffe in bekannter Weise hinzugefügt werden.

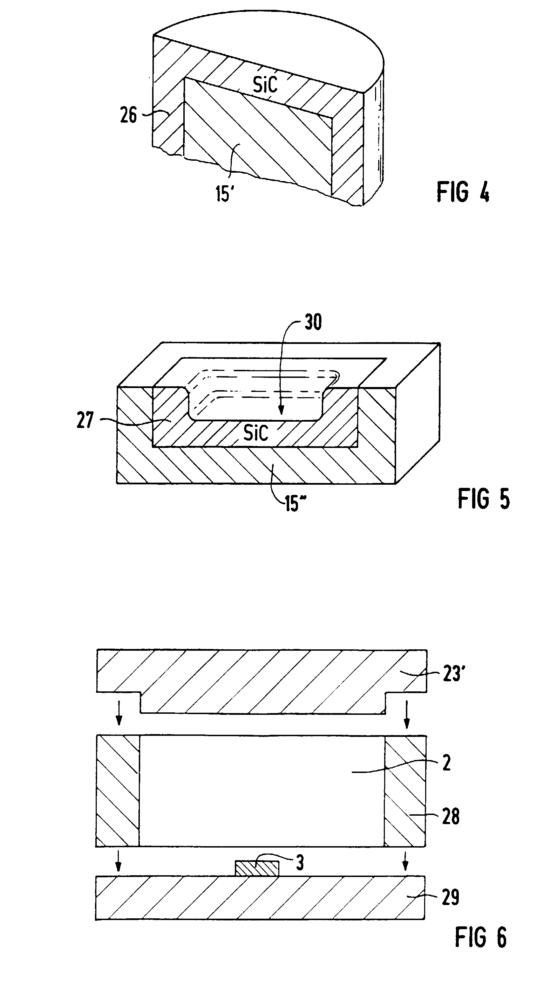

In den FIG 4 und 5 sind zwei weitere Möglichkeiten zur Herstellung von Formkörpern für die Wandung 20 der Reaktionskammer 2 dargestellt.

Im Ausführungsbeispiel der FIG 4 ist ein kreisscheibenförmiges Formsubstrat 15' vorgesehen, auf das eine Schicht aus SiC durch einen CVD-Prozeß abgeschieden wird. Es bildet sich somit als Formnegativ zu dem Formsubstrat 15' ein runder, topfförmiger Formkörper 26, der einem Hohlzylinder mit Boden entspricht.

In dem Ausführungsbeispiel der FIG 5 wird in eine quaderförmige Ausnehmung 30 eines ebenfalls quaderförmigen Formsubstrats 15" eine SiC-Schicht per CVD abgeschieden. Je nach Dauer der Abscheidung und der damit verbundenen Dicke der SiC-Schicht bildet sich ein Formkörper 27 unterschiedlicher Gestalt. Im dargestellten Ausführungsbeispiel der FIG 5 füllt die SiC-Schicht nicht die ganze Ausnehmung 30 aus, so daß ein wannenförmiger SiC-Formkörper 27 mit rechteckigem Grundriß entsteht. In beiden Ausführungsbeispielen der FIG 4 und der FIG 5 kann in einem darauffolgenden zweiten Verfahrensschritt das Formsubstrat 15' bzw. 15" entfernt werden und der verbleibende Formkörper 26 bzw. 27 für die Wandung 20 der Reaktionskammer 2 verwendet werden. Im Ausführungsbeispiel der FIG 5 kann allerdings auch das Formsubstrat 15" mit dem Formkörper 27 verbunden bleiben und als Verbundkörper für die Wandung 20 der Reaktionskammer 2 verwendet werden. Dabei bildet der mit der SiC-Schicht gebildete Formkörper 27 die Innenseite der Wandung 20.

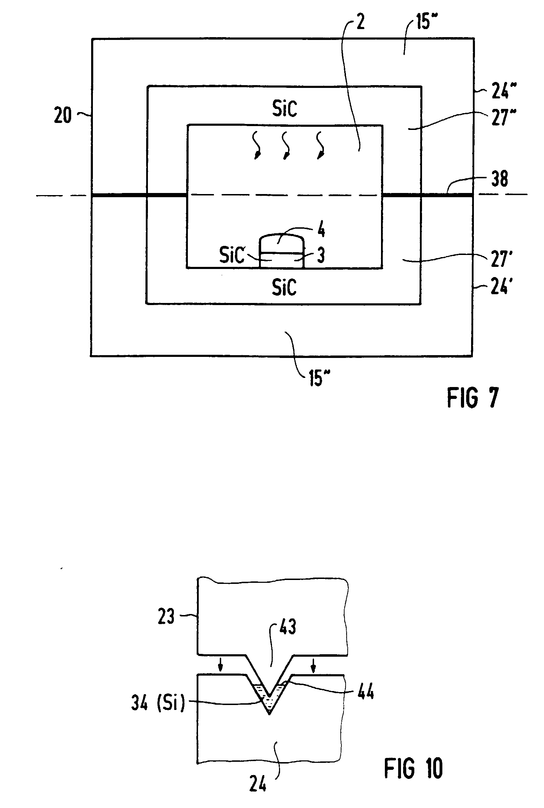

Im Ausführungsbeispiel der FIG 6 wird die Wandung 20 der Reaktionskammer 2 von drei Formkörpern 23', 28 und 29 gebildet, die vorzugsweise jeweils ganz aus durch einen CVD-Prozeß erzeugtem SiC bestehen. Der Formkörper 29 trägt als Bodenkörper den Keimkristall 3. Auf diesen Bodenkörper 29 wird ein hohlzylindrischer (rohrförmiger) Formkörper 28 aufgesetzt. Auf diesen hohlzylindrischen Formkörper 28 wird schließlich ein flanschartig gebildeter Formkörper 23' aufgesetzt, dessen Kanten mit den entsprechenden Kanten des Formkörpers 28 abschließen. Ein solcher flanschartiger Formkörper 23' kann beispielsweise mit einem Formsubstrat 15" gemäß FIG 5 hergestellt werden, indem man die SiC-Schicht auf dem Formsubstrat 15" so dick abscheidet, daß die Ausnehmung 30 ganz gefüllt wird und zusätzlich auf der weiteren Oberfläche des Formsubstrats 15" SiC abgeschieden wird.

In FIG 7 ist eine Reaktionskammer dargestellt, deren Wandung 20 von zwei gleich aufgebauten und miteinander verbundenen Formkörpern 24' und 24" gebildet ist. Die beiden Formkörper 24' und 24" werden bezüglich einer Spiegelebene, die die Verbindungsebene 38 definiert, symmetrisch miteinander verbunden. Die Formkörper 24' und 24" haben jeweils eine topfförmige Gestalt und sind jeweils wie im Ausführungsbeispiel der FIG 5 aus einem äußeren Teil und einem inneren Teil aus SiC aufgebaut. Der äußere Teil des Formkörpers 24' kann insbesondere aus Kohlenstoff (Graphit) bestehen und entspricht dem Formsubstrat 15" der FIG 5. Auf dem SiC-Formkörper 27' des unteren Formkörpers 24' ist der wenigstens eine Keimkristall 3 angeordnet, auf dem aus dem sublimierten SiC insbesondere des SiC-Formkörpers 27' des oberen Formkörpers 24" der SiC-Einkristall 4 aufwachst.

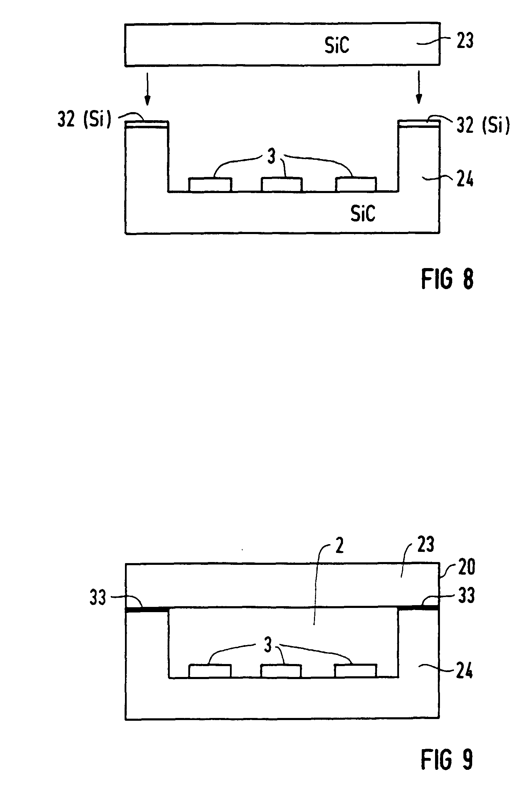

In den FIG 8 bis 10 sind besonders vorteilhafte Ausführungsformen zum Verbinden der Formkörper für die Wandung der Reaktionskammer dargestellt. Bei diesen Ausführungsformen wird zum Verbinden der Formkörper elementares Silicium verwendet.

Im Ausführungsbeispiel der FIG 8 wird auf einen topfförmigen Formkörper 24 aus SiC auf der Verbindungsfläche zu einem weiteren Formkörper 23 aus SiC wenigstens ein zusammenhängender Siliciumkörper 32 angeordnet. Der Siliciumkörper 32 kann ein insbesondere ringförmiges Plättchen oder auch eine auf dem Formkörper 24 abgeschiedene Siliciumschicht sein. Auf den Siliciumkörper 32 wird der Formkörper 23 angeordnet und die gesamte Anordnung wird in einem Ofen auf eine Temperatur gebracht, die höher als der Schmelzpunkt (1410°C) von Silicium liegt. Nach einer bestimmten Zeit bildet sich aus dem verflüssigten Silicium eine feste, gasdichte Verbindungsschicht 33 zwischen den beiden Formkörpern 23 und 24. Die so geformte Reaktionskammer 2 mit der Wandung 20 ist in FIG 9 dargestellt.

Die FIG 10 zeigt eine besondere Ausführungsform, bei der der Formkörper 23 einen Vorsprung 43 aufweist, der in einer entsprechenden Nut 44 im Formkörper 24 eingreift. Die Nut 44 des Formkörpers 24 wird nun mit Siliciumpulver 34 gefüllt und der Formkörper 23 wird so auf den Formkörper 24 aufgesetzt, daß der Vorsprung 43 in die Nut 44 eingreift. Nach Erhitzen auf eine Temperatur über der Schmelztemperatur des Siliciums bildet sich hier eine sichere, gasdichte Verbindung zwischen den beiden Formkörpern 23 und 24. Ein Vorteil besteht darin, daß das Siliciumpulver 34 in der Nut 44 besonders leicht eingefüllt werden kann. Siliciumpulver kann natürlich auch zur Verbindung von Formkörpern wie in FIG 8 oder FIG 9 verwendet werden. Durch das vor dem Erhitzen gasdurchlässige Siliumpulver kann insbesondere vor dem Versiegeln eine definierte Gasatmosphäre in der Reaktionskammer 2 eingestellt werden.

## Patentansprüche

1. Verfahren zum Herstellen von Siliciumcarbid-Einkristallen, bei dem
a) wenigstens eine von einer Wandung (20) gasdicht umschlossene Reaktionskammer (2) bereitgestellt wird, wobei die Wandung (20) wenigstens auf der der Reaktionskammer (2) zugewandten Innenseite (21) aus durch chemisches Abscheiden aus der Gasphase (CVD) hergestelltem Siliciumcarbid besteht,
b) wenigstens ein Teil des Siliciumcarbids der Wandung (20) sublimiert wird und auf wenigstens einem Keimkristall (3) als Siliciumcarbid-Einkristall (4) aufwächst,
c) die Wandung (20) der wenigstens einen Reaktionskammer (2) aus vorab gefertigten Formkörpern (23, 24) zusammengesetzt wird.

2. Verfahren nach Anspruch 1, bei dem elementares Silicium zum gasdichten Verbinden der Formkörper (23, 24) verwendet wird.

3. Vorrichtung zum Herstellen von Siliciumcarbid-Einkristallen mit
a) wenigstens einer von einer Wandung (20) gasdicht umschlossenen Reaktionskammer (2), wobei wenigstens die der Reaktionskammer (2) zugewandte Innenseite (21) der Wandung (20) aus durch chemisches Abscheiden aus der Gasphase (CVD) hergestelltem Siliciumcarbid besteht,
b) Mitteln zur Anordnung wenigstens eines Keimkristalls (3), so daß eine Kristallisationsfläche (9) des Keimkristalls (3) zum Aufwachsen eines Siliciumcarbid-Einkristalls (4) der Reaktionskammer (2) zugewandt ist, sowie mit
c) die Wandung (20) bildenden, vorab gefertigten Formkörpern (23, 24, 25).

4. Vorrichtung nach Anspruch 3, bei der Mittel zur Anordnung des wenigstens einen Keimkristalls (3) in der wenigstens einen Reaktionskammer (2) vorgesehen sind.

5. Vorrichtung nach Anspruch 3, bei der der wenigstens eine Keimkristall (3) aus Siliciumcarbid besteht und einen Teil der Wandung (20) der Reaktionskammer (2) bildet.

6. Vorrichtung nach Anspruch 3, bei der die Formkörper (23, 24) mit Hilfe von elementarem Silicium miteinander gasdicht verbunden sind.

7. Vorrichtung nach einem der Ansprüche 3 bis 6, bei der für den aus Siliciumcarbid bestehenden Teil der Wandung (20) zumindest weitgehend polykristallines Siliciumcarbid vorgesehen ist.

8. Vorrichtung nach einem der Ansprüche 3 bis 6, bei der für den aus Siliciumcarbid bestehenden Teil der Wandung (20) im wesentlichen amorphes Siliciumcarbid vorgesehen ist.

9. Vorrichtung nach einem der Ansprüche 3 bis 8, bei der das stöchiometrische Verhältnis von Silicium (Si) zu Kohlenstoff (C) im Siliciumcarbid wenigstens in einem Sublimationsbereich (22) der Wandung (20), der als Dampfquelle für den Sublimationsprozeß vorgesehen ist, nicht mehr als etwa 5 % von 1 abweicht.

10. Vorrichtung nach einem der Ansprüche 3 bis 9, bei der der wenigstens einen Reaktionskammer (2) thermische Mittel (50, 51, 6, 7, 8) zugeordnet sind zum Erhitzen und Sublimieren wenigstens eines Teils des Siliciumcarbids in einem Sublimationsbereich (22) der Wandung (20) und zum Einstellen einer vorgegebenen Temperaturverteilung zwischen Sublimationsbereich (22) und Keimkristall (3) in der wenigstens einen Reaktionskammer (2).

11. Vorrichtung nach einem der Ansprüche 3 bis 10, bei der der Anteil an Verunreinigungen im Siliciumcarbid der Wandung (20) 10¹⁵ cm⁻³ nicht wesentlich überschreitet.

## Claims

1. Method for producing silicon carbide monocrystals, where
a) at least one reaction chamber (2) enclosed in a gas-tight manner by a wall (20) is provided, with the wall (20) consisting at least on the inner side (21) facing the reaction chamber (2) of silicon carbide produced by chemical deposition from the gas phase (CVD),
b) at least one part of the silicon carbide of the wall (20) is sublimated and grows on at least one seed crystal (3) as silicon carbide monocrystal (4),
c) the wall (20) of the at least one reaction chamber (2) is composed of prefabricated shaped bodies (23, 24).

2. Method according to claim 1, where elemental silicon is used for the gas-tight connecting of the shaped bodies (23, 24).

3. Device for producing silicon carbide monocrystals, having
a) at least one reaction chamber (2) enclosed in a gas-tight manner by a wall (20), with at least the inner side (21) of the wall (20) which faces the reaction chamber (2) consisting of silicon carbide produced by chemical deposition from the gas phase (CVD),
b) means for the arrangement of at least one seed crystal (3) so that a crystallization surface (9) of the seed crystal (3) for growing a silicon carbide monocrystal (4) faces the reaction chamber (2), and having
c) prefabricated shaped bodies (23, 24, 25) which form the wall (20).

4. Device according to claim 3, where means for the arrangement of the at least one seed crystal (3) in the at least one reaction chamber (2) are provided.

5. Device according to claim 3, where the at least one seed crystal (3) consists of silicon carbide and forms a part of the wall (20) of the reaction chamber (2).

6. Device according to claim 3, where the shaped bodies (23, 24) are connected to each other in a gas-tight manner with the aid of elemental silicon.

7. Device according to one of claims 3 to 6, where at least largely polycrystalline silicon carbide is provided for the part of the wall (20) which consists of silicon carbide.

8. Device according to one of claims 3 to 6, where substantially amorphous silicon carbide is provided for the part of the wall (20) which consists of silicon carbide.

9. Device according to one of claims 3 to 8, where the stoichiometric relationship of silicon (Si) to carbon (C) in the silicon carbide at least in a sublimation region (22) of the wall (20), which is provided as vapour source for the sublimation process, differs from 1 by not more than about 5%.

10. Device according to one of claims 3 to 9, where thermal means (50, 51, 6, 7, 8) are allocated to the at least one reaction chamber (2) for heating and sublimating at least a part of the silicon carbide in a sublimation region (22) of the wall (20) and for setting a specified temperature distribution between the sublimation region (22) and the seed crystal (3) in the at least one reaction chamber (2).

11. Device according to one of claims 3 to 10, where the proportion of impurities in the silicon carbide of the wall (20) does not substantially exceed 10¹⁵ cm⁻³.

## Revendications

1. Procédé de fabrication de monocristaux de carbure de silicium, dans lequel :
a) on prend au moins une chambre de réaction (2), qui est d'une manière étanche aux gaz entourée d'une paroi (20), la paroi (20) étant, au moins sur sa face intérieure (21) dirigée vers la chambre de réaction (2), constituée de carbure de silicium préparé par déposition chimique en phase vapeur (CVD),
b) au moins une partie du carbure de silicium de la paroi (20) est sublimée, et subit une croissance sur au moins un germe cristallin (3) sous forme d'un monocristal de carbure de silicium (4),
c) la paroi (20) de la ou des chambres de réaction (2) est constituée d'objets façonnés préfabriqués (23, 24).

2. Procédé selon la revendication 1, dans lequel on utilise du silicium élémentaire pour assurer une liaison étanche aux gaz des objets façonnés (23, 24).

3. Appareil pour fabriquer des monocristaux de carbure de silicium, comportant
a) au moins une chambre de réaction (2), qui d'une manière étanche aux gaz est entourée d'une paroi (20), au moins la face intérieure (21), dirigée vers la chambre de réaction (2), de la paroi (20) étant constituée d'un carbure de silicium fabriqué par déposition chimique en phase vapeur (CVD),
b) des moyens pour disposer au moins un germe cristallin (3) de façon qu'une surface de cristallisation (9) du germe cristallin (3), destinée à la croissance d'un monocristal de carbure de silicium (4), soit dirigée vers la chambre de réaction (2), et aussi
c) des objets façonnés préfabriqués (23, 24, 25) formant la paroi (20).

4. Appareil selon la revendication 3, dans lequel on a prévu des moyens pour disposer le ou les germes cristallins (3) dans la ou les chambres de réaction (2).

5. Appareil selon la revendication 3, dans lequel au moins un germe cristallin (3) est constitué de carbure de silicium et forme une partie de la paroi (20) de la chambre de réaction (2).

6. Appareil selon la revendication 3, dans lequel les objets façonnés (23, 24) sont reliés les uns aux autres d'une manière étanche aux gaz à l'aide de silicium élémentaire.

7. Appareil selon l'une des revendications 3 à 6, dans lequel, pour la partie de la paroi (20) constituée de carbure de silicium, on prévoit un carbure de silicium au moins presque complètement polycristallin.

8. Appareil selon l'une des revendications 3 à 6, dans lequel, pour la partie de la paroi (20) constituée de carbure de silicium, on prévoit un carbure de silicium essentiellement amorphe.

9. Appareil selon l'une des revendications 3 à 8, dans lequel le rapport stoechiométrique du silicium (Si) au carbone (C) dans le carbure de silicium, au moins dans une zone de sublimation (22) de la paroi (20) qui doit servir de source de vapeur pour le procédé de sublimation, s'écarte de 1 d'une valeur non supérieure à environ 5 %.

10. Appareil selon l'une des revendications 3 à 9, dans lequel des moyens thermiques (50, 51, 6, 7, 8) sont affectés à la ou aux chambres de réaction (2), pour assurer le chauffage et la sublimation d'au moins une partie du carbure de silicium dans une zone de sublimation (22) de la paroi (20) et pour ajuster une distribution prédéfinie des températures entre la zone de sublimation (22) et le germe cristallin (3) dans la ou les chambres de réaction (2).

11. Appareil selon l'une des revendications 3 à 10, dans lequel la proportion d'impuretés dans le carbure de silicium de la paroi (20) ne dépasse pas sensiblement 10¹⁵ cm⁻³.
